(19) Europäisches Patentamt
European Patent Office
Office européen des brevets

(11) **EP 1 684 551 B1**

(12) **EUROPEAN PATENT SPECIFICATION**

(45) Date of publication and mention
of the grant of the patent:
**01.09.2010 Bulletin 2010/35**

(51) Int Cl.:
**H01L 51/50** [(2006.01)]   **C09K 11/06** [(2006.01)]
**H01L 27/32** [(2006.01)]   **H05B 33/14** [(2006.01)]
**H05B 33/22** [(2006.01)]

(21) Application number: **04792705.8**

(22) Date of filing: **14.10.2004**

(86) International application number:
**PCT/JP2004/015555**

(87) International publication number:
**WO 2005/039247 (28.04.2005 Gazette 2005/17)**

(54) **ORGANIC ELECTRO-LUMINESCENCE DISPLAY PANEL**

ORGANISCHE ELEKTROLUMINESZENZ-DISPLAY-TAFEL

PANNEAU D'AFFICHAGE ELECTROLUMINESCENT ORGANIQUE

(84) Designated Contracting States:
**DE FR GB**

(30) Priority: **16.10.2003 JP 2003356438**

(43) Date of publication of application:
**26.07.2006 Bulletin 2006/30**

(73) Proprietor: **Pioneer Corporation
Tokyo 153-8654 (JP)**

(72) Inventors:
• **NAGAYAMA, Kenichi,
Pioneer Corporation, R & D Lab.
Tsurugashima-shi,
Saitama 350-2288 (JP)**
• **OCHI, Hideo,
Pioneer Corporation, Corp. R & D Lab.
Tsurugashima-shi,
Saitama 350-2288 (JP)**

• **ISHIZUKA, Shinichi,
Pioneer Corporation, R & D Lab
Tsurugashima-shi,
Saitama 350-2288 (JP)**
• **SHIRATORI, Masahiro,
Pioneer Corporation R & D Lab
Tsurugashima-shi,
Saitama 350-2288 (JP)**
• **IWASAKI, Shingo,
Pioneer Corporation, R & D Lab.
Tsurugashima-shi,
Saitama 350-2288 (JP)**

(74) Representative: **Manitz, Finsterwald & Partner
GbR
Martin-Greif-Strasse 1
80336 München (DE)**

(56) References cited:
**EP-A2- 1 052 708     WO-A-01/01488
GB-A- 2 332 985     JP-A- 11 087 062
JP-A- 2001 196 186     JP-A- 2003 045 665**

**Description**

TECHNICAL FIELD

The present invention relates to an organic electroluminescence element (hereinafter, refer to as organic EL element) having at least one thin film (hereinafter, referred to as organic function layer) including an emission layer comprising an organic compound material that shows electroluminescence, that is, emitting light by current injection, or, particularly, relates to an organic electroluminescence display panel (hereinafter, referred to as organic EL display panel) in which a plurality of organic EL elements are formed on a substrate.

BACKGROUND ART

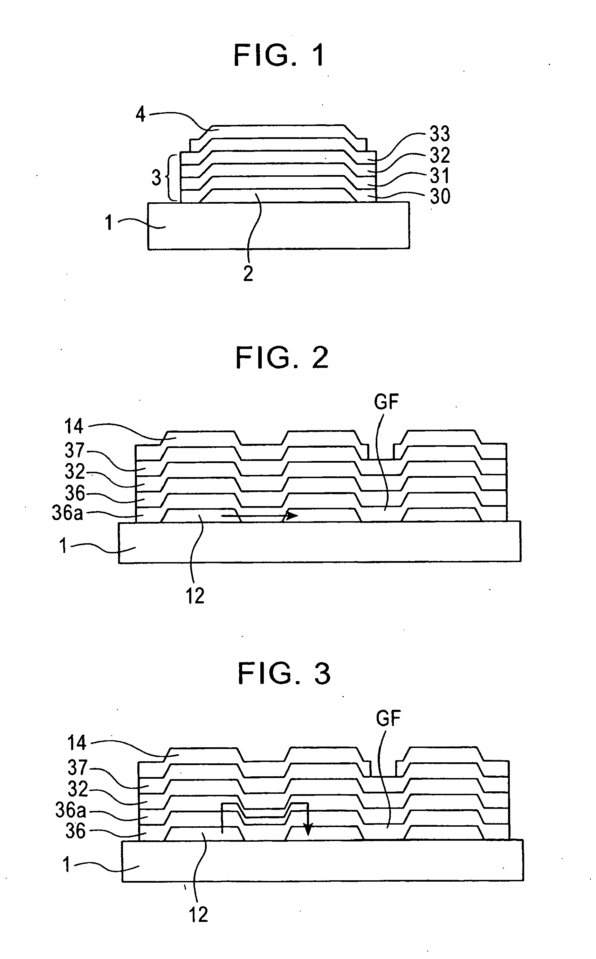

The organic EL element is essentially configured in a form that the organic function layer including the emission layer is sandwiched between an anode that is a display electrode and a cathode, wherein exciton generated in recombination of electrons and holes injected from the both electrodes returns from an excited state to the ground state, causing light emission. For example, as shown in Fig.1, a transparent electrode 2 as the anode, an organic function layer 3, and a metal electrode 4 as the cathode are sequentially stacked on a transparent substrate 1, thereby the organic EL device is configured, and light is emitted from a transparent substrate side. To lead out the emission light, at least one of the anode and the cathode needs to be transparent or semitransparent. The organic function layer 3 comprises, for example, as shown in Fig.1, a plurality of layers having a function respectively, such as hole injection layer 30, hole transport layer 31, emission layer 32, and electron transport layer 33 stacked from the transparent electrode 2 side. Among the plurality of layers, the hole injection layer contacting to the anode may be handled as a part of the anode or a buffer layer, and the electron injection layer contacting to the cathode as a part of the cathode or the buffer layer. The hole injection layer and the hole transport layer comprise a material having hole transport properties, and the electron transport layer and the electron injection layer comprise a material having electron transport properties. The charge transport layers other than the emission layer improve efficiency of charge injection to the emission layer, and largely improve emission efficiency compared with an element comprising a single emission layer. In an actual organic EL element, there is a type without the charge transport layer, or a type with four layers or more. Also, in some cases, the emission layer may comprise a plurality of layers, for example, a white emission element comprises two layers of a blue emission layer and a red emission layer.

Using the plurality of organic EL elements, an organic EL display panel having the capability of color display is proposed.

For example, an organic EL display panel structure including a plurality of coloring regions having a patterned multi-color emission layer, and a hole injection band or an electron injection band formed for an entire surface of the multi-color emission layer is proposed (See patent document 1 below).

On the other hand, when a conductive compound is formed on the entire surface as the hole injection layer as described in the patent document 1, electric leakage occurs between the electrodes. To point this problem, and prevent the electric leakage among pixels or organic EL elements, an organic EL display panel structure is proposed, in which the charge injection layer and the emission layer are formed separately for each pixel in order to prevent a material forming these layers from extending among the pixels, thereby the electric leakage among the pixels is prevented. (See patent document 2 below).

Although there is a method as a technique disclosed in the patent document 2 in which the charge transport layer is separately formed for each pixel to prevent the electric leakage, as pointed in the patent document 1, there has been a problem that the formation of the charge transport layer for each pixel leads to complexity of a process, and when the charge transport layer is imperfectly patterned, a short-circuit between the anode and the cathode occurs, resulting in reduction in reliability of the organic EL display panel.

Further, document 3 provides an organic EL display device having high quality and high yields by preventing partial shorts between electrodes or approximate shorted condition, thus preventing emission errors and uneven emission due to the generation of leakage currents.

Patent document 1: Japanese Patent Kokai No. 2000-150152
Patent document 2: Japanese Patent Kokai No. 1999-087062
Patent document 3: Japanese Patent Kokai No. 2003-045665

DISCLOSURE OF THE INVENTION

Thus, as a problem to be solved in the invention, it is given as an example to provide an organic EL display panel in which the problem of the electric leakage among the pixels is eliminated, and reliability is high by using a conductive charge transport layer having relatively low resistance such as conductive polymer.

The organic electroluminescence display panel of the present invention is defined in claims 1 and 2.

BRIEF DESCRIPTION OF THE DRAWINGS

Fig.1 is a cross section view schematically showing an organic EL device.
Fig.2 is a partial cross section view schematically showing an organic EL display panel.
Fig.3 is a partial cross section view schematically showing an organic EL display panel.
Fig.4 is a partial cross section view schematically showing an organic EL display panel.
Fig.5 is a partial cross section view schematically showing an organic EL display panel of an embodiment according to the invention.
Fig.6 is a view showing a pulse electric signal to the organic EL device applied with current-control-type gray-scale driving.
Fig.7 is a view showing a pulse electric signal to the organic EL device applied with voltage-control-type gray-scale driving.
Fig.8 is a partial plan view schematically showing a part of substrate of the organic EL display panel in a process of producing a passive-matrix organic EL display panel of another embodiment according to the invention.
Fig.9 is a partial plan view schematically showing a part of substrate of the organic EL display panel in a process of producing an active-matrix organic EL display panel of another embodiment according to the invention.
Fig.10 is a partial plan view schematically showing a part of substrate of an organic EL display panel in a process of producing a segment-type organic-EL-display panel of another embodiment according to the invention.
Fig.11 is a partial cross section view schematically showing an organic EL display panel of another embodiment according to the invention.

MODE FOR CARRYING OUT OF THE INVENTION

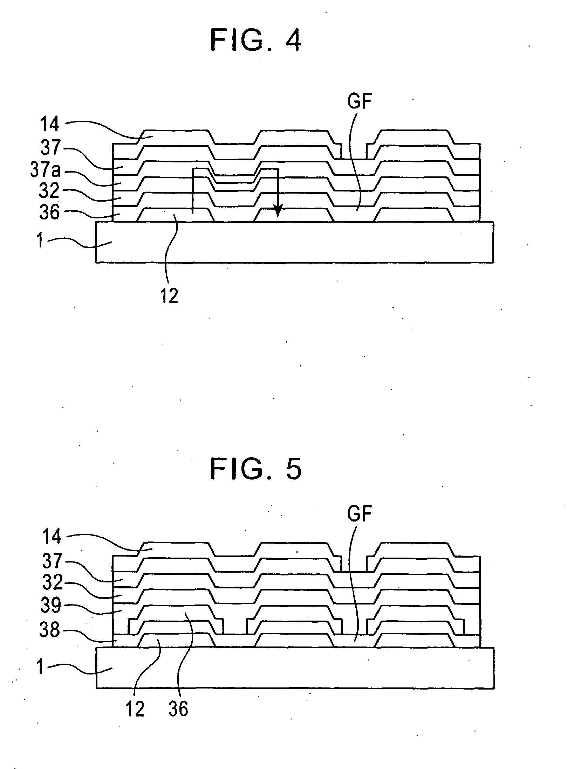

Embodiments of the invention are described with reference to drawings.
The invention was made by quantitatively reviewing the electric leakage among pixels, what-is-called organic EL elements, from a new viewpoint of driving conditions (driving method, driving voltage, and gray-scale number of display) and an electrode pattern, and introducing a completely new idea.
Fig.2 to Fig.4 show sections of organic EL display panels having organic EL display elements comprising organic function layers stacked between first and second electrodes respectively. Numeral 1 indicates a substrate, numeral 12 indicates the first electrode, numeral 36 indicates a first charge transport layer, numeral 32 indicates an emission layer, numeral 37 indicates a second charge transport layer, numerals 36a and 37a indicate charge transport layers with low resistance, and numeral 14 indicates the second electrode. When the charge transport layer with low resistance 36a is located at a position contacting to the first electrode 12 as Fig.2, the electric leakage (arrow) among the pixels becomes significant. As shown in Fig.3, even if the charge transport layer with low resistance 36a does not contact to the electrode, when the layer is located between the emission layer 32 and the first electrode 12, although depending on a junction condition at each interface, a leakage path (arrow) may exist.
As shown in Fig.4, when the charge transport layer with low resistance is located between the emission layer 32 and the second electrode 14 at an opposite side, no significant problem occurs. The reason for this is that, in leakage paths shown in Fig.4, a portion from the second charge transport layer 37 to the first charge transport layer 36 is in a reverse junction condition, resulting in extremely high resistance, therefore the amount of the leakage current is small.
When a material having comparatively low resistance such as conductive polymer is used for the charge transport layer such as hole injection layer, and the layer is formed for a plurality of pixels, as shown in Fig.2 to Fig.4, the electric leakage occurs at a gap filling part GF extending among the pixels, and various problems occur depending on driving methods.
For example, when a pixel is driven by constant voltage driving, if a driving circuit has a sufficient margin in current capacity, even if the electric leakage occurs, an amount of electric current flowing into the pixel is equal to a normal case without the electric leakage, therefore luminance of the pixel is equal to the case of a normal pixel. However, excess current that is not responsible for emission flows into an electrode of an adjacent pixel due to the electric leakage, increasing power consumption.
On the other hand, when a pixel is driven by constant current driving, if the electric leakage occurs, electric current to be flown into the pixel flows into the electrode of the adjacent pixel due to the electric leakage, therefore electric current flowing into the pixel decreases compared with the normal case by the amount corresponding to the electric leakage, resulting in decrease in luminance. Particularly, when gray-scale display is performed, luminance of a pixel to be displayed in a particular gray-scale n is reduced, and when the pixel becomes dark compared with a normal pixel in a gray-scale n-1, monotone increasing characteristics of the gray-scale is deteriorated, thereby accurate gray-scale expression becomes impossible. When the driving circuit has not sufficient current capacity in the constant voltage driving, the accurate gray-scale expression is also impossible as the constant current driving.

Thus, the invention focuses attention on the driving conditions or gray-scale expression, and optimizes sheet resistance of the conductive charge transport layer, particularly the gap filling part GF of the layer extending among the pixels such that the gray-scale expression is not reversed by the leakage current caused by the conductive charge transport layer.

Moreover, the invention optimizes the sheet resistance of the conductive charge transport layer such that power consumption is not significantly increased by the leakage current caused by the conductive charge transport layer.

Since the leakage current flows through the conductive charge transport layer located among electrodes of adjacent pixels, magnitude of the leakage current is determined by resistance R_gap of the conductive charge transport layer located among the pixels (gap filling part GF).

Fig.5 shows an example of a structure of the organic EL element according to the invention. Numeral 1 indicates the substrate, numeral 12 indicates the first electrode, numerals 38 and 39 indicate solid-formed charge transport layers, numeral 32 indicates the emission layer, numeral 37 indicates a second charge transport layer, numeral 14 indicates the second electrode, and GF indicates the gap filling part.

Solid-formed charge transport layers 38 and 39 corresponding to the first charge transport layer are formed over a plurality of the first electrodes. Combined sheet resistance $\rho s\_ctl$ of the two solid-formed charge transport layers is expressed by parallel sum of sheet resistance $\rho s\_ctl1$ and $\rho s\_ctl2$ of the solid-formed charge transport layers 38 and 39, and given by the following formula.

$$1 / \rho s\_ctl = 1 / \rho s\_ctl1 + 1 / \rho s\_ctl2 \qquad \cdots \text{ formula (1)}$$

When the solid-formed charge transport layer comprises three or more layers, the sheet resistance can be also obtained by the parallel sum, and when the solid-formed charge transport layer comprises a single layer, the sheet resistance of the layer can be established to be $\rho s\_ctl$. When a value of $\rho s\_ctl1$ greatly differs from a value of $\rho s\_ctl2$, for example, when the difference is one hundred times or more, and $\rho s\_ctl1 > 100 \cdot \rho s\_ctl2$, calculation may be performed assuming that $\rho s\_ctl$ is $\rho s\_ctl2$. Moreover, since the charge transport layer is formed solidly, sheet resistance of the gap filling part of the layer, which extends among the pixels, is uniform.

Resistance R_gap between a pixel and adjacent, other pixel is obtained as the following formula.

$$R\_gap = a \cdot \rho s\_ctl \qquad\qquad\qquad \cdots \text{ formula (2)}$$

(where R_gap indicates resistance of the gap filling part between the adjacent pixels, and a indicates a coefficient obtained from a shape of the gap filling part.)

Actually, a pattern of the emission part defined by the first and second electrodes is complicated, therefore the value of a is not simply determined, and the resistance R_gap of the gap filling part needs to be calculated in accordance with a pattern of each pixel or electrode (described later).

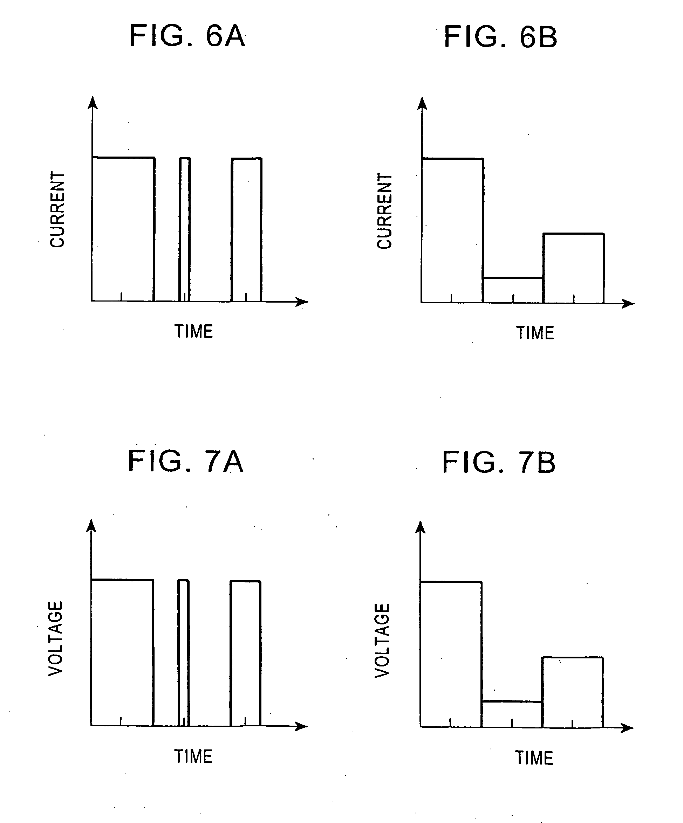

Generally, emission luminance of the organic EL element is controlled in order to obtain a display gray-scale according to image data, and actual driving is performed by providing pulsed electric signals to the device, as shown in Fig.6 and Fig.7 in rough classification. The luminance control includes a current control method (constant current driving) where driving current to the element is controlled as Fig. 6(A)(B), and a voltage control method (constant voltage driving) where driving voltage is controlled as Fig.7(A)(B). Specifically, as shown in Fig.6(B) and Fig.7(B), luminance of the element is changed by changing the amount of the driving current or the driving voltage according to luminance data. On the other hand, as shown in Fig.6(A) and Fig.7(A), the luminance of the element can be also changed by changing current supply time or voltage supply time according to the luminance data at a constant level of the driving current or driving voltage.

Hereinafter, the invention is described separately in cases that the pixel driving is performed by (1) the constant current driving and (2) the constant voltage driving.

(1) Case of pixel driving by constant current driving--

The constant current driving is a driving method where the element is driven by flowing constant electric-current into the pixel according to luminance. In the constant current driving, the electric leakage reduces the current flowing into the pixel, resulting in decrease in luminance of the pixel. Furthermore, since the current flowing into the pixel is reduced, driving voltage of the pixel is reduced compared with a case without the electric leakage.

Accordingly, when a pixel with the electric leakage is adjacent to an approximately normal pixel without the electric leakage, and both of them are in an on-state and emitting, human eyes, which are sensitive to luminance difference among the adjacent pixels, sense decrease in luminance of the pixel with the electric leakage, and feel deterioration of display quality at a particular level or more of luminance difference.

(1-1) Luminance difference between adjacent pixels--

A consideration is made on the electric leakage in a pixel, where the luminance difference between the adjacent pixels is not sensible, and sheet resistance in a display unit. The pixel in which the electric leakage occurs and the luminance is reduced must emit light in an approximately similar way as the adjacent, normal pixel. The luminance of the pixel with the electric leakage needs to be in a ratio or less of luminance of an adjacent pixel, which can not be recognized to be changed by a viewer, to the luminance of the normal pixel without the electric leakage. Thus, the following formula needs to be satisfied.

$$\text{L\_ng} \geqq f \cdot L \quad (0 < f < 1) \quad \cdots \text{ formula (3)}$$

(where L indicates the luminance of the normal pixel without the electric leakage, L_ng indicates the luminance of the pixel with the electric leakage, and f indicates a ratio of the luminance of the adjacent pixel, which can be recognized to be changed by humans, respectively.)

In the organic EL element, the emission luminance is in proportion to the electric current flowing into the element above a threshold applied-voltage. Also, average luminance of a pixel is in proportion to a period while the element actually emits light. For simplicity, when a case where the device is driven by a square wave is considered, the luminance of the pixel L is expressed by the following formula without regard to presence of the electric leakage.

$$L = \alpha \cdot I \cdot t \quad \cdots \text{ formula (4)}$$

(where $\alpha$ indicates luminous efficiency, I indicates the current applied to the pixel, and t indicates emission time of the pixel, respectively.)

Accordingly, the formula (3) is derived as the following formula from the formula (4).

$$\alpha \cdot \text{I\_ng} \cdot t \geqq \alpha \cdot f \cdot I \cdot t$$
$$\text{Consequently, } \text{I\_ng} \geqq f \cdot I \quad \cdots \text{ formula (5)}$$

(where I_ng indicates the current flowing into the pixel with the electric leakage.)

On the other hand, when the amount of the current flowing into the adjacent pixel from the pixel with the electric leakage through the gap filling part is assumed to be I_leak, since I_leak=I-I_ng, the amount of the leakage current is derived as the following formula from the formula (5) .

$$\text{I\_leak} \leqq (1 - f) \cdot I \quad \cdots \text{ formula (6)}$$

Here, when the ratio of the luminance difference between the adjacent pixels, which can be recognized as luminance change by humans, is assumed to be j, since j=1-f, the amount of the leakage current is given as the following formula.

$$\text{I\_leak} \leqq j \cdot I \quad \cdots \text{ formula (7)}$$

The amount of the leakage current needs to satisfy the formula (7) so that the luminance difference between the adjacent pixels is not sensible to the human eyes.

The amount of the leakage current I_leak in a pixel is maximized when all the pixels adjacent to the pixel through the gap filling part are in an off-state. At that time, relation between I_leak and the sheet resistance ρs_ctl of the charge transport layer is given as the following formulas.

$$\mathtt{I\_leak \cdot R\_gap = V\_on\_ng - V\_off} \qquad \cdots \mathtt{formula\ (8)}$$

$$\mathtt{R\_gap = a \cdot \rho s\_ctl} \qquad \cdots \mathtt{formula\ (9)}$$

(where R_gap indicates resistance of the gap filling part between a pixel and adjacent, other pixel, V_on_ng indicates first electrode potential of a pixel with the electric leakage occurring in the on-state (when the first electrode is a scan electrode of a simple-matrix, it indicates electric potential in a scan-on state), V_off indicates first electrode potential of a pixel adjacent to the pixel with the electric leakage in the off-state (when the first electrode is the scan electrode of the simple-matrix, it indicates electric potential in a scan-off state), ρs_ctl indicates the sheet resistance of the charge transport layer solidly formed at the first electrode side, and a is the coefficient obtained from the shape of the gap filling part, respectively.)

When I_leak is not significantly large, since the first electrode potential V_on_ng of the pixel with the electric leakage in the on-state is approximately equal to the first electrode potential of the pixel adjacent to the pixel with the electric leakage in the on-state, the sheet resistance of the charge transport layer between the adjacent pixels is derived as the following formula from the formula (8) and the formula (9).

$$\mathtt{\rho s\_ctl = (V\_on - V\_off) / (I\_leak \cdot a)} \qquad \cdots \mathtt{formula\ (10)}$$

(where V_on indicates the first electrode potential in the on-state of the pixel adjacent to the pixel with the electric leakage.)

As known from the formula (10), the amount of the leakage current I_leak decreases with increase of the sheet resistance ρs_ctl of the solid-formed charge transport layer. Thus, when I_leak is maximized, ρs_ctl is minimized. Accordingly, the maximum allowed value I_leak_max of I_leak, and the minimum sheet resistance ρs_ctl_min of the sheet resistance ρs_ctl of the solid-formed charge transport layer can be determined from the formula (6) and the formula (10). Specifically, the minimum ρs_ctl_min is derived as the following formula from the formula (7) and the formula (10).

$$\mathtt{\rho s\_ctl\_min = (V\_on - V\_off) / (j \cdot I \cdot a)} \qquad \cdots \mathtt{formula\ (11)}$$

Accordingly, in the organic EL element according to the invention, the sheet resistance ρs_ctl of the solid-formed charge transport layer is larger than ρs_ctl_min obtained in this manner.

A value of a ratio j of the luminance difference of the adjacent pixel that can be recognized to be changed by humans is different depending on use of the display unit and viewers. How large the value of j is was obtained from the following experiment. It was known from results of the experiment that the value of j is desired to be preferably 0.08 or less, and more preferably 0.05 or less. From the value of j and the formula (11), the minimum ρs_ctl_min of the sheet resistance ρs_ctl of the solid-formed charge transport layer can be determined.

{Experiment on luminance difference of adjacent pixel}

An experiment on the value of the ratio j of the luminance difference of the adjacent pixel, which can be recognized to be changed by humans, was conducted.

A green monochrome organic-EL-panel with 256x64 dots, in which a left half is emitted at luminance of 100 $cd/m^2$ and luminance of a right half is gradually dropped from 100 $cd/m^2$, was exhibited to 26 subjects. A sign was made by the subject at a point when the subject was able to recognize luminance change, and the luminance of the right half was recorded at that time, thereby what degree of the ratio of luminance difference was able to be recognized by humans was investigated. For example, when the subject made the sign of the luminance change at the luminance of the right half of 97 cd/m$^2$, the luminance difference that was able to be recognized by the subject, or what-is-called the luminance difference coefficient was 3% (j=0.03).

Table 1 shows the luminance difference recognized by the subjects and the number of persons. It was known that a half of persons recognized the luminance difference at the luminance difference of approximately 5% (j=0.05), and all the persons at the luminance difference of 8% (j=0.08).

Table 1

| LUMINANCE DIFFERENCE RECOGNIZED BY SUBJECTS(%) | NUMBER OF PERSONS WHO RECOGNIZED (NUMBER) | TOTAL NUMBER OF PERSONS (NUMBER) | RATIO OF TOTAL NUMBER OF PERSONS (%) |
|---|---|---|---|
| 1 | 2 | 2 | 7.7 |
| 2 | 0 | 2 | 7.7 |
| 3 | 1 | 3 | 11.5 |
| 4 | 5 | 8 | 30.8 |
| 5 | 6 | 14 | 53.8 |
| 6 | 9 | 23 | 88.5 |
| 7 | 1 | 24 | 92.3 |
| 8 | 2 | 26 | 100 |

(1-2) Luminance of adjacent pixel and gray-scale--

In the display unit, in some cases, difference between the maximum luminance and the minimum luminance of the emission part is divided by a predetermined level to be a luminance gray-scale, and display is performed with a plurality of divided luminance levels such as 1/24 in 24 gray-scales and 1/32 in 32 gray-scales. In the gray-scale display, when a pixel with the electric leakage in a particular level or more exists, the luminance difference between the adjacent pixels is recognized, and reversal between the gray-scale and the luminance may occur. To prevent the reversal between the gray-scale and the luminance, the pixel having reduced luminance due to the electric leakage must emit light brightly above the luminance of the normal pixel in a gray-scale one level lower than a desired gray-scale. Thus, the following formula needs to be satisfied in a particular gray-scale.

$$\mathrm{L\_ng(m) > L(m-1)} \qquad \cdots \text{formula (14)}$$

(where L(m) indicates luminance of the normal (without the electric leakage) pixel in a gray-scale m, and L_ng(m) indicates luminance of the pixel with the electric leakage in the gray-scale m, respectively.)

In the organic EL device, electric current flowing into the element is in proportion to the emission luminance. Also, average luminance of a pixel is in proportion to the period while the element actually emits light. For simplicity, when a case that the element is driven by the square wave is considered, the following formula is given without regard to presence of the electric leakage,

$$\mathrm{L(m) = \alpha \cdot I(m) \cdot t(m)} \qquad \cdots \text{formula (15)}$$

(where I(m) indicates electric current applied to the pixel in the gray-scale m, and t(m) indicates emission time of the pixel in the gray-scale m, respectively.)

The following formula is given from the formula (14) and the formula (15).

$$I\_ng(n) \cdot t(n) > I(n-1) \cdot t(n-1) \qquad \cdots \text{formula (16)}$$

When the amount of the electric current due to the electric leakage is assumed as I_leak, the following formula is given.

$$I\_ng(n) = I(n) - I\_leak(n) \qquad \cdots \text{formula (17)}$$

(where I_leak(n) indicates electric current flowing into the adjacent pixel through the gap filling part due to the electric leakage in the pixel in a gray-scale n.)

The following formula is given from the formula (16) and the formula (17).

$$I\_leak(n) \cdot t(n) < I(n) \cdot t(n) - I(n-1) \cdot t(n-1) \qquad \cdots \text{formula (18)}$$

Accordingly, the formula (18) needs to be satisfied in any gray-scale n.

The amount of the leakage current I_leak(n) in a particular pixel is maximized when all the pixels adjacent to the pixel through the gap filling part are in the off-state. At that time, relation between I_leak and the sheet resistance ρs_ctl of the charge transport layer is expressed by the following formulas.

$$I\_leak(n) \cdot R\_gap = V\_on\_ng(n) - V\_off \qquad \cdots \text{formula (19)}$$

$$R\_gap = a \cdot \rho s\_ctl \qquad \cdots \text{formula (20)}$$

(where R_gap is the resistance between the pixel and the adjacent, other pixel, V_on_ng(n) (n≥1) indicates the first electrode potential of the pixel in which the electric leakage occurs in the on-state and at a gray-scale n (when the first electrode is the scan electrode of the simple-matrix, it is the electric potential in the scan-on state), V_off indicates the first electrode potential of the adjacent pixels in the off-state (generally, it is equal to the first electrode potential V_on (0) at the lowest gray-scale, however, when the first electrode is the scan electrode of the simple-matrix, it is the electric potential in the scan-off state), ρs_ctl indicates the sheet resistance of the charge transport layer solidly formed at the first electrode side, and a indicates the coefficient obtained from the shape of the gap filling part, respectively.)

The following formula is given from the formula (19) and the formula (20).

$$\rho s\_ctl = (V\_on\_ng(n) - V\_off) / (I\_leak(n) \cdot a) \qquad \cdots \text{formula (21)}$$

As seen from the formula (21), the amount of the leakage current I_leak(n) decreases with increase of the sheet resistance ρs_ctl of the solid-formed charge transport layer. Thus, when I_leak is maximized, ρs_ctl is minimized. Accordingly, the maximum I_leak_max of the allowed value of I_leak(n) and the minimum ρs_ctl _min of the sheet resistance ρs_ctl of the solid-formed charge transport layer can be determined from the formula (18) and the formula (21).

In the organic EL display panel according to the invention, the sheet resistance ρs_ctl of the solid-formed charge transport layer is made to be larger than ρs_ctl _min based on the value of the ratio j of the luminance difference of the adjacent pixel, which can be recognized as the luminance change by the humans.

Hereinafter, the invention is described in more detail with an example of a further specific method of gray-scale expression.

The luminance L(m) is determined by establishing the gray-scale m and the luminance. For example, in a driving method with the gray-scale number k where m is 0 to (k-1), luminance at the maximum gray-scale is L(K-1), and luminance at the minimum gray-scale is L(0), and in intermediate gray-scales between them, the gray-scale is made to be in proportion to the luminance. Thus, in general setting of the gray-scale that is given linearly, the luminance L(m) is expressed as the following formula.

$$\mathrm{L(m)} = \mathrm{m} \cdot \mathrm{L(K-1)} / \mathrm{(K-1)} \qquad \cdots \quad \text{formula (22)}$$

(where L(K-1) indicates luminance at the gray-scale number K-1 in the gray-scale m.)
In addition, it is expressed as the following formula at m=k-1 from the formula (15).

$$\mathrm{L(K-1)} = \alpha \cdot \mathrm{I(K-1)} \cdot \mathrm{t(K-1)} \qquad \cdots \quad \text{formula (23)}$$

(where I(K-1) indicates electric current flowing into a pixel with the gray-scale number K-1 in the gray-scale m, and t(K-1) indicates the emission time of the pixel with the gray-scale number K-1 in the gray-scale m, respectively.)
The following formula is given from the formula (22) and the formula (23).

$$\mathrm{L(m)} = \mathrm{m} \cdot \alpha \cdot \mathrm{I(K-1)} \cdot \mathrm{t(K-1)} / \mathrm{(K-1)} \qquad \cdots \quad \text{formula (24)}$$

When the right sides of the formula (15) and the formula (24) are assumed to be equal to each other, the following formula is given.

$$\mathrm{I(m)} \cdot \mathrm{t(m)} = \mathrm{m} \cdot \mathrm{I(K-1)} \cdot \mathrm{t(K-1)} / \mathrm{(K-1)} \qquad \cdots \quad \text{formula (25)}$$

From the formula (25), the right side of the formula (18) is expressed as the following formula.

$$\mathrm{I(n)} \cdot \mathrm{t(n)} - \mathrm{I(n-1)} \cdot \mathrm{t(n-1)}$$
$$= \mathrm{n} \cdot \mathrm{I(K-1)} \cdot \mathrm{t(K-1)} / \mathrm{(K-1)} - \mathrm{(n-1)} \cdot \mathrm{I(K-1)} \cdot \mathrm{t(K-1)} / \mathrm{(K-1)}$$
$$= \mathrm{I(K-1)} \cdot \mathrm{t(K-1)} / \mathrm{(K-1)} \qquad \cdots \quad \text{formula (26)}$$

Accordingly, the formula (18) is expressed as the following formula.

$$\mathrm{I\_leak(n)} \cdot \mathrm{t(n)} < \mathrm{I(K-1)} \cdot \mathrm{t(K-1)} / \mathrm{(K-1)} \qquad \cdots \quad \text{formula (27)}$$

The maximum I_leak_max of I_leak satisfying the formula (21) and the formula (27), and the minimum $\rho$s_ctl _min of the sheet resistance $\rho$s_ctl of the solid-formed charge transport layer will be obtained.
Here, a consideration is made separately in cases that the gray-scale expression is performed by (a) pulse width modulation (the gray-scale expression is performed using time length of flowing electric current), and (b) pulse amplitude modulation (the gray-scale expression is performed using magnitude of the electric current flown).

(1a) Case using pulse width modulation

In the pulse width modulation, the gray-scale expression is performed using pulse length (that is, period of applying electric current) at constant pulse amplitude (that is, electric current). Thus, it is expressed as the following formula.

$$I(m) = I\_const \qquad\qquad \cdots \text{formula (28)}$$

(where I_const indicates the constant driving current.)

The following formula is given from the formula (25) and the formula (28).

$$t(m) = m \cdot t(K\text{-}1) / (K\text{-}1) \qquad\qquad \cdots \text{formula (29)}$$

The following formula is given from the formula (27), the formula (28), and the formula (29).

$$I\_leak(n) < I\_const / n \qquad\qquad \cdots \text{formula (30)}$$

From the formula (30), I_leak(n) is maximized when n is maximized, or n=K-1, and it is expressed as the following formula.

$$I\_leak\_max = I\_leak(K\text{-}1) = I\_const / (K\text{-}1) \qquad \cdots \text{formula (31)}$$

The following formula is given from the formula (21), the formula (28), and the formula (31).

$$\rho s\_ctl\_min = (V\_on\_ng(K\text{-}1) - V\_off) \cdot (K\text{-}1) / (I\_const \cdot a)$$
$$\cdots \text{formula (32)}$$

A value of V_on_ng(m) is determined from the amount of the leakage current, that is, determined by $\rho s\_ctl$, therefore $\rho s\_ctl\_min$ can not be simply determined from the equation (32). However, driving voltage of the first electrode V_on(m) of the pixel without the electric leakage is obtained from element characteristics. As described before, in the constant current driving, since the driving voltage of the pixel with the electric leakage is reduced compared with the case without the electric leakage, the driving voltage V_on(m) of the first electrode is expressed by the following formula.

$$V\_on(m) > V\_on\_ng(m) \qquad\qquad \cdots \text{formula (33)}$$

(where V_on(m) indicates the first electrode potential of the pixel without the electric leakage in the on-state and at the gray-scale m (m≥1) (when the first electrode is the scan electrode of the simple-matrix, it is voltage in the scan-on state).

When V_on(m) is substituted for V_on_ng(m) in the formula (32), the value of $\rho s\_ctl\_min$ becomes large, that is, the minimum of $\rho s\_ctl$ is increased and conditions become severe, therefore the value is expressed as the following formula.

$$\rho s\_ctl\_min = (V\_on(K\text{-}1) - V\_off) \cdot (K\text{-}1) / (I\_const \cdot a)$$
$$\cdots \text{formula (34)}$$

The value of $\rho s\_ctl\_min$ is obtained from this formula, and the value of $\rho s\_ctl$ is satisfactorily set to the obtained value or more.

(1b) Case using pulse amplitude modulation

In the pulse amplitude modulation, the gray-scale expression is performed using the amplitude of the pulse (that is, current) at a constant pulse length (that is, time of applying electric current). Thus, the following formula is given.

$$t(m) = t\_const \qquad\qquad \cdots formula\ (35)$$

(where t_const indicates constant driving time.)
The following formula is given from the formula (25) and the formula (35).

$$I(m) = m \cdot I(K-1) / (K-1) \qquad\qquad \cdots formula\ (36)$$

The following formula is given from the formula (27), formula (35), and formula (36).

$$I\_leak(n) < I(K-1) / (K-1) \qquad\qquad \cdots formula\ (37)$$

The following formula is given from the formula (21) and the formula (37).

$$(V\_on\_ng(n) - V\_off) / (\rho s\_ctl \cdot a) < I(K-1) / (K-1)$$
$$\cdots formula\ (38)$$

Consequently,

$$\rho s\_ctl > (V\_on\_ng(n) - V\_off) \cdot (K-1) / (a \cdot I(K-1))$$
$$\cdots formula\ (39)$$

The most severe condition among conditions obtained by the formula (39), that is, the case that the value of $\rho s\_ctl$ must be maximized is a case that V_on_ng(n) is maximized, that is, n=k-1. At that time, assuming that the formula 39 is an equation, the following formula is given.

$$\rho s\_ctl\_min = (V\_on\_ng(k-1) - V\_off) \cdot (K-1) / (a \cdot I(K-1))$$
$$\cdots formula\ (40)$$

As described before, when V_on(n) is substituted for V_on_ng(n) in the formula (40), the value of ps_ctl_min is increased. Thus, the minimum of $\rho s\_ctl$ is increased and the conditions become severe. Therefore, ps_ctl_min is obtained from the following formula,

$$\rho s\_ctl\_min=(V\_on(K-1)-V\_off)\cdot(K-1)\diagup(a\cdot I(K-1))$$

$$\cdots \text{formula (41)},$$

and the value of ρs_ctl is satisfactorily set to the obtained value or more.

(2) Case of pixel driving by constant voltage driving--

The constant voltage driving is a driving method where the element is driven by applying constant voltage to the pixel according to luminance.
In the constant current driving, if the driving circuit has a sufficient current capacity, the electric leakage does not reduce the electric current flowing into the pixel, and luminance of the pixel is maintained. Thus, even if the electric leakage occurs, the driving voltage of the pixel is not affected. That is, the following formula is given.

$$V\_on\_ng(m)=V\_on(m) \qquad \cdots \text{formula (50)}$$

On the other hand, in the constant voltage driving, the electric leakage increases the amount of electric current, resulting in increase in power consumption corresponding to the amount.
To suppress the increase in power consumption, it is desirable that the amount of the leakage current is restrained to be preferably 1/10 or less to the electric current flowing into the element, and more preferably 1/100 or less. Thus, when the following formula is given:

$$I\_leak(n)=b\cdot I(n) \qquad \cdots \text{formula (51)},$$

it is desirable that a value of b is preferably 1/10 or less, and more preferably 1/100 or less. By modifying the formula (21), the following formula is given.

$$I\_leak(n)=(V\_on\_ng(n)-V\_off)\diagup(\rho s\_ctl\cdot a)$$

$$\cdots \text{formula (52)}$$

The following formula is given from the formula (50), formula (51), and formula (52).

$$b=(V\_on(n)-V\_off)\diagup(I(n)\cdot \rho s\_ctl\cdot a) \quad \cdots \text{formula (53)}$$

It is desirable that, for any n, the value of b obtained from the formula (53) is preferably 1/10 or less, and more preferably 1/100 or less. The minimum ρs_ctl_min10 of the sheet resistance ρs_ctl of the solid-formed charge transport layer when b is 1/10 in the formula (52), and the minimum ρs_ctl_min100 of ρs_ctl when b is 1/100 are obtained. In the invention, ρs_ctl is preferably made to be ρs_ctl_min10 or more, and more preferably ρs_ctl_min100 or more.
Here, a consideration is made separately in cases that the gray-scale expression is performed by (a) the pulse width modulation (the gray-scale expression is performed using the time length of flowing electric current) and (b) the pulse amplitude modulation (the gray-scale expression is performed using the magnitude of the electric current flown).

(2a) Case by pulse width modulation

In the pulse width modulation, the gray-scale expression is performed using the pulse length (that is, time of applying voltage) at a constant pulse amplitude (that is, voltage). When the voltage is constant, the current I (m) flowing into the pixel is also constant. Thus, these are expressed by the following formulas.

$$V\_on(m) = V\_const \qquad \cdots \text{ formula (54),}$$

$$I(m) = I\_const \qquad \cdots \text{ formula (55)}$$

(where V_const indicates the constant driving voltage, and I_const indicates the electric current (independent of the gray-scale) flowing into the pixel when the voltage is V_const.)
The following formula is given from the formula (53), formula (54), and formula (55).

$$b = (V\_const - V\_off) / (I\_const \cdot \rho s\_ctl \cdot a) \qquad \cdots \text{ formula (56)}$$

By modifying the formula (56), the following formula is given.

$$\rho s\_ctl = (V\_const - V\_off) / (b \cdot a \cdot I\_const) \qquad \cdots \text{ formula (57)}$$

In the formula (57), assuming that b is 1/10 and 1/100, the following formula is given.

$$\rho s\_ctl10 = 10 \cdot (V\_const - V\_off) / (I\_const \cdot a) \qquad \cdots \text{ formula (58)}$$

$$\rho s\_ctl100 = 100 \cdot (V\_const - V\_off) / (I\_const \cdot a) \qquad \cdots \text{ formula (59)}$$

From these formulas, $\rho s\_ctl\_min10$ and $\rho s\_ctl\_min100$ can be obtained.

(2b) Case by pulse amplitude modulation

In the pulse amplitude modulation, the gray-scale expression is performed using the amplitude (that is, voltage) of the pulse at a constant pulse length (that is, time of applying voltage). Thus, it is expressed by the following formula.

$$t(m) = t\_const \qquad \cdots \text{ formula (60)}$$

(where t_const indicates the constant driving time.)

From the formula (53), the following formula is given.

$$\rho s\_ctl = (V\_const - V\_off) / (b \cdot a \cdot I(n)) \quad \cdots \text{ formula (61)}$$

The formula (61) is not particularly changed by the formula (60). Since the organic EL device has diode-like characteristics, current increases exponentially with increase of voltage. That is, the value of V_on(n)/I(n) becomes large as n becomes small. Also, since the value of V_off/I(n) becomes large as n becomes small, the case that the conditions are most severe, or b is maximized is a case that n is minimized, or n=1 from the formula (61). At that time, assuming that b is 1/10 and 1/100, the following formulas are given.

$$\rho s\_ctl10 = 10 \cdot (V\_on(1) - V\_off) / (I(1) \cdot a)$$

$$\cdots \text{ formula (62)}$$

$$\rho s\_ctl100 = 100 \cdot (V\_on(1) - V\_off) / (I(1) \cdot a)$$

$$\cdots \text{ formula (63)}$$

From these formulas, $\rho s\_ctl\_min10$ and $\rho s\_ctl\_min100$ can be obtained.

In any driving methods, when the resistance of the charge transport layer is excessively large, the driving voltage of the element becomes high, causing deterioration in device characteristics, therefore, as described in Japanese Patent Kokai H10-92584, it is desirable that the sheet resistance of the charge transport layer is smaller than $10^{16}$ $\Omega$/$\Box$, preferably smaller than $10^{15}$ $\Omega$/$\Box$, and more preferably smaller than $10^{14}$ $\Omega$/$\Box$.

A known material can be used for the electrode and the organic function layer used in the organic EL device according to the invention. Particularly, for the charge transport layer having the conducting properties, for example, a metal oxide, metal nitride, and conductive polymer can be used. To apply the materials for the invention, the sheet resistance needs to be controlled.

To control the sheet resistance, control of film thickness is the most simple and easy method. In another method, specific resistance is controlled. Specifically, the sheet resistance can be controlled by changing oxygen content in the metal oxide, changing nitrogen content in the metal nitride, or changing a dopant level in the conductive polymer of a type where dopant is used to impart conductivity.

Embodiment and Comparative Example

An emissive display panel according to the invention was prepared according to the following procedure.

(1) Formation of first electrode (anode)

ITO was deposited 150 nm thick on a grass substrate by sputter method. Next, the photoresist AZ 6112 produced by TOKYO OHKA KOGYO CO., LTD. was patterned on the ITO film. The substrate was dipped in a mixed solution of a ferric chloride solution and hydrochloric acid, and the ITO in the area that was not covered by the resist was etched. Finally, the substrate was dipped in acetone to remove the resist, thereby a stripe electrode pattern comprising 480 lines was obtained. The stripe ITO pattern had a line width of 120 $\mu$m and a gap w of 10 $\mu$m (pitch of 130 $\mu$m). Length 1 of the ITO line in a display area was 46.8 mm.

(2) Formation of conductive charge transport layer

The substrate in (1) was sufficiently washed, and then spin coated with a polyaniline solution produced by NISSAN CHEMICAL INDUSTRIES, LTD. Subsequently, unnecessary areas other than the display area of the spin coated film were wiped out using acetone. In addition, the substrate was heated on a hot plate at four conditions (samples A to D) to vaporize solvent, thereby a polyaniline film 20 nm thick was formed in the display area. Heating conditions of samples A to D are shown in Table 2.

Table 2

| SAMPLE | HEATING CONDITIONS | | SHEET RESISTANCE $(\Omega/\square)$ |
|---|---|---|---|
| | TEMPERATURE (°C) | TIME (min) | |
| A | | 15 | 8.0E+09 |
| B | 200 | 30 | 5.4E+09 |
| C | | 60 | 4.0E+08 |
| D | | 240 | 1.2E+11 |

Sheet resistance of the formed polyaniline films was measured using MCP-HT260 produced by MITSUBISHI CHEMICAL CORPORATION. The measurement results are shown together in Table 2.
The sheet resistance of the polyaniline film was varied depending on the heating conditions. It is considered that this is because oxidation conditions of the film are varied depending on heating situations.

(3) Formation of other organic function layers and second electrode (cathode)--

On the substrate in (2), as organic function layers other than the conductive charge transport layer, $\alpha$-NPD 25 nm thick and Alq3 60 nm thick were formed in the display area by an evaporation method using a mask. In addition, as a cathode, Al-Li alloy was formed 100 nm thick by the evaporation method using a mask in a 120 stripe pattern having a line width of 250 $\mu$m and a gap of 140 $\mu$m (pitch of 390 $\mu$m).
The sheet resistance of the formed $\alpha$-NPD film was measured in a same way as (1), as a result the resistance was too large to be measured. From the measuring range of the measuring instrument, the sheet resistance of the $\alpha$-NPD film is considered to be $1\times10^{15}$ $\Omega/\square$ or more.

(4) Sealing--

A glass plate having a dent and a desiccant attached to the dent portion was adhered to the substrate in (3) using a UV curing adhesive for sealing, and thus the organic EL element comprising a simple matrix of 480x120 pixels was completed according to the invention.

(5) Connection and adjustment of driving circuit

The element in (4) was connected to a desired driving circuit, and the driving circuit was adjusted such that luminance L_(K-1) of a pixel at the maximum gray-scale in the on-state was 100 cd/m$^2$. At that time, for the pixel, voltage V_on (K-1) applied to the anode was 10.5 V, and voltage V_off applied to the anode in the off-state was 3.5 V, and voltage applied to a cathode side of the element in the on-state was 0 V (GND). In the case that the gray-scale number K was set to 256, 64, 16, or 4, and the gray-scale was established linearly, when the element was driven by various driving methods to emit light, the driving voltage and driving current were given as shown in Table 3.

Table 3A

| GRAY-SCALE K | DRIVE METHOD | MODULATION METHOD | DRIVING VOLTAGE | | | |
|---|---|---|---|---|---|---|
| | | | V_off (V) | V_on (V) | V_on(K-1) (V) | V_const (V) |
| 256 | CONSTANT CURRENT | PULSE WIDTH | 3.50 | - | 10.50 | - |
| 256 | | AMPLITUDE | 3.50 | - | 10.50 | - |
| 256 | CONSTANT VOLTAGE | PULSE WIDTH | 3.50 | - | - | 10.50 |
| 256 | | AMPLITUDE | 3.50 | 4.50 | - | - |

(continued)

| GRAY-SCALE K | DRIVE METHOD | MODULATION METHOD | DRIVING VOLTAGE | | | |
|---|---|---|---|---|---|---|
| | | | V_off (V) | V_on (V) | V_on(K-1) (V) | V_const (V) |
| 64 | CONSTANT CURRENT | PULSE WIDTH | 3.50 | - | 10.50 | - |
| 64 | | AMPLITUDE | 3.50 | - | 10.50 | - |
| 64 | CONSTANT VOLTAGE | PULSE WIDTH | 3.50 | - | - | 10.50 |
| 64 | | AMPLITUDE | 3.50 | 5.10 | - | - |
| 16 | CONSTANT CURRENT | PULSE WIDTH | 3.50 | - | 10.50 | - |
| 16 | | AMPLITUDE | 3.50 | - | 10.50 | - |
| 16 | CONSTANT VOLTAGE | PULSE WIDTH | 3.50 | - | - | 10.50 |
| 16 | | AMPLITUDE | 3.50 | 6.20 | - | - |
| 4 | CONSTANT CURRENT | PULSE WIDTH | 3.50 | - | 10.50 | - |
| 4 | | AMPLITUDE | 3.50 | - | 10.50 | - |
| 4 | CONSTANT VOLTAGE | PULSE WIDTH | 3.50 | - | - | 10.50 |
| 4 | | AMPLITUDE | 3.50 | 8.30 | - | - |

Table 3B

| GRAY-SCALE K | DRIVE METHOD | MODULATION METHOD | DRIVING CURRENT | | |
|---|---|---|---|---|---|
| | | | I_(1) (A) | I_(K-1) (A) | I_const (A) |
| 256 | CONSTANT CURRENT | PULSE WIDTH | - | - | 7.40E-05 |
| 256 | | AMPLITUDE | 2.90E-07 | 7.40E-05 | - |
| 256 | CONSTANT VOLTAGE | PULSE WIDTH | 7.40E-05 | - | - |
| 256 | | AMPLITUDE | 2.90E-07 | | - |
| 64 | CONSTANT CURRENT | PULSE WIDTH | - | - | 7.40E-05 |
| 64 | | AMPLITUDE | 1.17E-06 | 7.40E-05 | - |
| 64 | CONSTANT VOLTAGE | PULSE WIDTH | 7.40E-05 | - | - |
| 64 | | AMPLITUDE | 1.17E-06 | | - |
| 16 | CONSTANT CURRENT | PULSE WIDTH | - | - | 7.40E-05 |
| 16 | | AMPLITUDE | 4.93E-06 | 7.40E-05 | - |
| 16 | CONSTANT VOLTAGE | PULSE WIDTH | 7.40E-05 | - | - |
| 16 | | AMPLITUDE | 4.93E-06 | | - |
| 4 | CONSTANT CURRENT | PULSE WIDTH | - | - | 7.40E-05 |
| 4 | | AMPLITUDE | 2.47E-05 | 7.40E-05 | - |
| 4 | CONSTANT VOLTAGE | PULSE WIDTH | 7.40E-05 | - | - |
| 4 | | AMPLITUDE | 2.47E-05 | | - |

Table 3C

| GRAY-SCALE K | DRIVE METHOD | MODULATION METHOD | MINIMUM OF SHEET RESISTANCE (CALCULATED VALUE) | | |
|---|---|---|---|---|---|
| | | | $\rho s\_cti\_min$ (Ω/□) | $\rho s\_ctl10$ (Ω/□) | $\rho s\_ctl100$ (Ω/□) |
| 256 | CONSTANT CURRENT | PULSE WIDTH | 2.3E+11 | - | - |
| 256 | | AMPLITUDE | 2.3E+11 | - | - |
| 256 | CONSTANT VOLTAGE | PULSE WIDTH | - | 8.9E+09 | 8.9E+10 |
| 256 | | AMPLITUDE | - | 3.2E+11 | 3.2E+12 |
| 64 | CONSTANT CURRENT | PULSE WIDTH | 5.6E+10 | - | - |
| 64 | | AMPLITUDE | 5.6E+10 | - | - |
| 64 | CONSTANT VOLTAGE | PULSE WIDTH | - | 8.9E+09 | 8.9E+10 |
| 64 | | AMPLITUDE | - | 1.3E+11 | 1.3E+12 |
| 16 | CONSTANT CURRENT | PULSE WIDTH | 1.3E+10 | - | - |
| 16 | | AMPLITUDE | 1.3E+10 | - | - |
| 16 | CONSTANT VOLTAGE | PULSE WIDTH | - | 8.9E+09 | 8.9E+10 |
| 16 | | AMPLITUDE | - | 5.1E+10 | 5.1E+11 |
| 4 | CONSTANT CURRENT | PULSE WIDTH | 2.7E+09 | - | - |
| 4 | | AMPLITUDE | 2.7E+09 | - | - |
| 4 | CONSTANT VOLTAGE | PULSE WIDTH | - | 8.9E+09 | 8.9E+10 |
| 4 | | AMPLITUDE | - | 1.8E+10 | 1.8E+11 |

The coefficient a determined by the shape of the gap filling part is calculated as a=D/2M=0.010 mm/2·46.8 mm≒ $1.07 \times 10^{-4}$ using the gap width D and the electrode length M.

Since the sheet resistance of α-NPD is two or more orders in magnitude higher than that of the polyaniline film, when the sheet resistance of the first charge transport layer of the prepared element is calculated, only the sheet resistance of the polyaniline film may be considered.

Sheet resistance necessary for the driving conditions in Table 3 is obtained according to the invention, and additionally shown in Table 3. A case that the sheet resistance of the polyaniline film is larger than the minimum of the calculated sheet resistance in Table 3 is a practical example of the invention, and a smaller case is a comparative example. In each case, whether the practical example or the comparative example is appropriate is determined depending on the prepared elements and driving conditions for grouping, and results of the grouping are shown in Table 4. In the case of the constant voltage driving, the determination was made using the value of $\rho s\_ctl\_min10$ as a basis.

Table 4

| GRAY-SCALE K | DRIVING METHOD | MODULATION METHOD | HEATING CONDITIONS OF PPLYANILINE | | | |
|---|---|---|---|---|---|---|
| | | | A | B | C | D |
| 256 | CONSTANT CURRENT | PULSE | × | × | × | × |
| 256 | | AMPLITUDE | × | × | × | × |
| 256 | CONSTANT VOLTAGE | PULSE | × | × | × | ○ |
| 256 | | AMPLITUDE | × | × | × | × |
| 64 | CONSTANT CURRENT | PULSE | × | × | × | ○ |
| 64 | | AMPLITUDE | × | × | × | ○ |
| 64 | CONSTANT VOLTAGE | PULSE | × | × | × | ○ |
| 64 | | AMPLITUDE | × | × | × | × |

(continued)

| GRAY-SCALE K | DRIVING METHOD | MODULATION METHOD | HEATING CONDITIONS OF PPLYANILINE | | | |
|---|---|---|---|---|---|---|
| | | | A | B | C | D |
| 16 | CONSTANT CURRENT | PULSE | × | × | × | ○ |
| 16 | | AMPLITUDE | × | × | × | ○ |
| 16 | CONSTANT VOLTAGE | PULSE | × | × | × | ○ |
| 16 | | AMPLITUDE | × | × | × | ○ |
| 4 | CONSTANT CURRENT | PULSE | ○ | ○ | × | ○ |
| 4 | | AMPLITUDE | ○ | ○ | × | ○ |
| 4 | CONSTANT VOLTAGE | PULSE | × | × | × | ○ |
| 4 | | AMPLITUDE | × | × | × | ○ |
| Note: In the table, open circle is an example of the embodiment, and cross is a comparative example. | | | | | | |

The prepared element was driven by the constant current driving, and switched in a manner where the first electrode lines were repeatedly turned on (the maximum gray-scale) and turned off (the minimum gray-scale) at three line intervals, and emission condition was observed. The emission condition was observed using an optical microscope, as a result decrease in luminance due to the electric leakage was observed in the element in the heating condition C where sheet resistance of the polyaniline film was particularly low. In the emission condition of the element in the heating condition C, an aspect that electric current was leaked into adjacent, first-electrode-lines in a turned-off state, causing decrease in luminance was confirmed.

On the other hand, in the heating condition D where the sheet resistance is high, the decrease in luminance due to the electric leakage was hardly observed.

The luminance of pixels was measured in a case that all the pixels were turned on at a gray-scale one level lower than the maximum gray-scale (a condition where no electric leakage occurs), and a case that the first electrodes were turned on at one line intervals at the maximum gray-scale (a condition where the electric leakage is maximized), and a comparison between the two was made, as a result the reversal of the gray-scale did not occur in the conditions of the practical examples shown in Table 4.

In the description, while the sheet resistance of the first charge transport layer at the first electrode side has been described, for the sheet resistance of the second charge transport layer at the second electrode side, the minimum can be obtained in a same manner.

In the organic EL element according to the invention, since the sheet resistance of the charge transport layer is set to an optimum sheet resistance that is derived from the element structure such as the pattern of the electrode or the driving conditions, when pixels are driven by the constant voltage driving, the excessive amount of current, which is flown into the electrodes of adjacent pixels due to the electric leakage and not responsible for emission, can be suppressed and thus the power consumption can be restrained. A merit in the case of the constant current driving is improvement in display quality.

Moreover, since the charge transport layer can be formed commonly for a plurality of elements, process is simple. In addition, the charge transport layer is sufficiently formed on the entire surface, a short circuit between the anode and the cathode scarcely occurs.

As above, according to the invention, an organic EL display in which the problem of the electric leakage among the pixels is eliminated, and reliability or element performance is high can be realized in a simple process using the conductive charge transport layer having comparatively low resistance such as the conductive polymer.

{Resistance of gap filling part depending on electrode pattern}

Relation between the resistance of the gap filling part among the adjacent pixels and the sheet resistance of the panel, which was indicated by the formula 2, formula 9, and formula 20, is described in detail. A pattern of each of the organic EL elements in the organic EL display panel is complicated, and the value of the coefficient a obtained from the shape of the gap filling part is not simply determined, and the resistance R_gap of the gap filling part needs to be calculated in accordance with a pattern of an individual pixel or the electrode, therefore the coefficient a is determined depending on the pattern.

(1) Case of simple-matrix panel

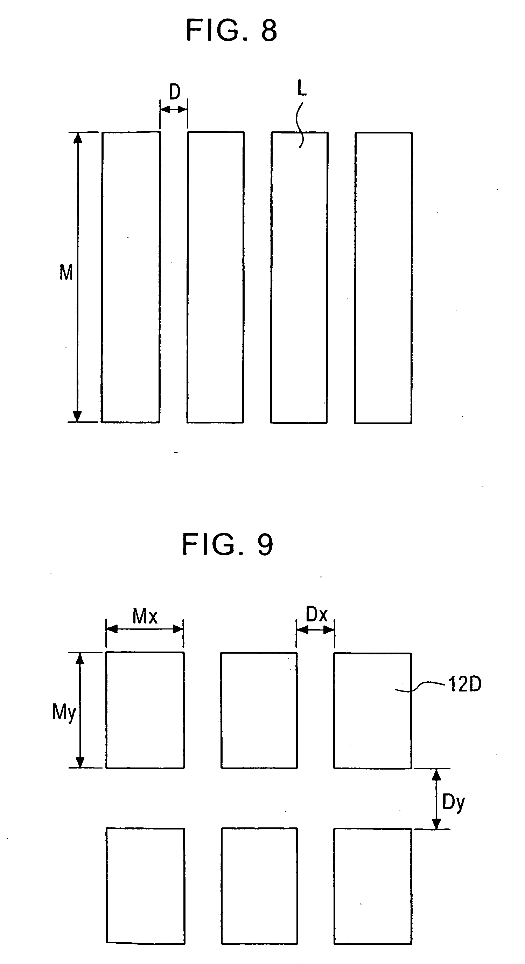

As shown in Fig.8, a plurality of elements in a passive-matrix organic EL display panel are disposed on anode lines L arranged with the gap filling part GF among them. Since an anode line and other anode lines are formed at an equal distance (pitch) in any place, R_gap is in proportion to a line-to-line distance D, and in inverse proportion to line length M. When the worst case such as a case where lines at both adjacent sides of an anode line of a turned-on pixel are in the off-state, and potential difference is increased, leading to leakage of electric current is considered, the following formula is given.

$$\mathrm{R\_gap} = \rho\, \mathrm{s\_ctl} \cdot \mathrm{D} \diagup 2\,\mathrm{M} \qquad\qquad \cdots \text{formula (73)}$$

(where D indicates the line-to-line distance, and M indicates the line length, respectively.)
Accordingly, in the light of the formula (2), the coefficient a obtained from the shape of the gap filling part is given as the following formula.

$$\mathrm{a} = \mathrm{D} \diagup 2\,\mathrm{M} \qquad\qquad \cdots \text{formula (74)}$$

(2) Case of active matrix panel

In the active-matrix organic EL display panel, a plurality of pixels are separated from each together, and a TFT (Thin Film Transistor) circuit comprising a FET (Field Effect Transistor) and a capacitor is provided for each pixel (emission part). Accordingly, as shown in Fig.9, since display electrodes 12D of the emission part are spread all over the substrate with the gap filling part GF among them, when the electrode is, for example, rectangular, and length of sides are assumed to be $L_x$, $L_y$, and distances among the display electrodes are assumed to be $D_x$, $D_y$, R_gap is approximated as the following formula.

$$\mathrm{R\_gap} = \rho\, \mathrm{s\_ctl} \diagup [\, 2 \cdot \{(\mathrm{Mx} \diagup \mathrm{Dy}) + (\mathrm{My} \diagup \mathrm{Dx})\}\,]$$

$$\cdots \text{formula (75).}$$

Accordingly, in the light of the formula 2, the coefficient a obtained from the shape of the gap filling part is given as the following formula.

$$\mathrm{a} = \mathrm{D} \diagup [\, 2 \cdot \{(\mathrm{Mx} \diagup \mathrm{Dy}) + (\mathrm{My} \diagup \mathrm{Dx})\}\,] \qquad \cdots \text{formula (76)}$$

(3) Case of segment-type display panel

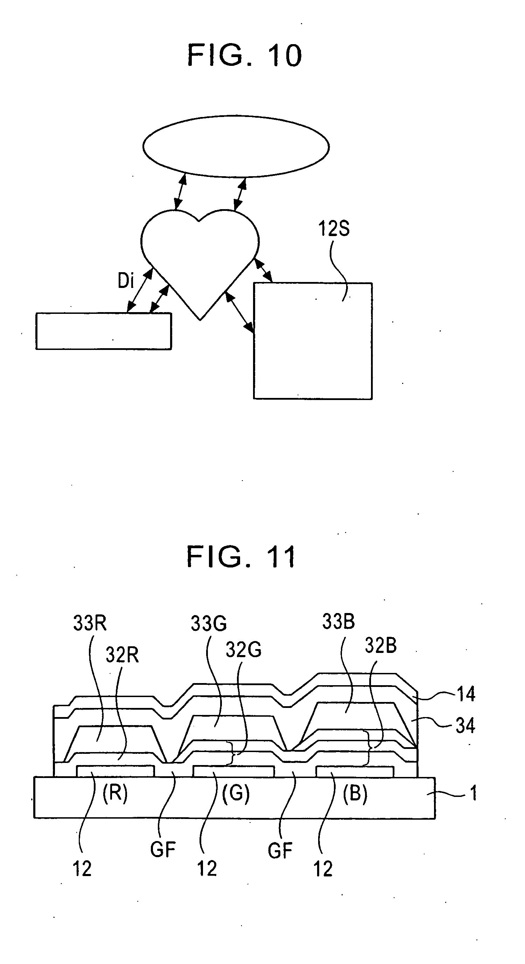

As shown in Fig.10, in the segment-type organic EL display panel, a plurality of arbitrarily-patterned pixels are disposed on the substrate with the gap filling part GF among them, therefore distances from respective peripheral points of a segment electrode 12S to other segment electrodes are all different.
Circumferential length of a segment is assumed to be M_seg, and divided into n parts. Assuming that distances from respective sides to the other segments are $D_i$, resistance can be calculated, and total resistance R_gap, which is parallel sum of the calculated resistance, is approximated as the following formula. Actually, calculation can be made assuming that n is a finite value.

$$\frac{1}{R\_gap} = \lim_{n \to \infty} \frac{M\_seg}{\rho s\_ctl \bullet n} \sum_{i=1}^{n} \frac{1}{Di} \qquad\qquad \cdots \text{formula (77)}$$

Accordingly, in the light of the formula 2, the coefficient a obtained from the shape of the gap filling part is set to satisfy the following formula.

$$\frac{1}{a} = \lim_{n \to \infty} \frac{M\_seg}{n} \sum_{i=1}^{n} \frac{1}{Di} \qquad \cdots \text{formula (78)}$$

{Another Embodiment}

In the above practical examples, while a monochrome emission panel, in which the polyaniline film is formed on the gap filling part and the solid-formed charge transport layer in a same thickness for each element, has been described, the invention can be also applied to a multicolor emission panel. It is sufficient only that the gap filling part is deposited in common, and the charge transport layer can be formed in different thickness for each element.

As shown in Fig.11, on a first electrode 12 (anode) such as ITO on a transparent substrate 1 such as glass, for example, hole transport layers 32R, 32G, 32B are formed as the charge transport layer of the element, and the hole transport layers are deposited such that each of the layers has a different thickness such as 50 nm, 70 nm, and 100 nm, for example, for each of emission parts of red, green, and blue or RGB. First, the layer is deposited in only difference thickness as a result of subtracting the common thickness from the thickness to be deposited on respective emission area of RGB. That is, the layer is deposited in a thickness of 20 nm or 50 nm, which is the thickness after subtracting a thickness of 50 nm common to respective emission areas, on G or B emission area, respectively. A material of the hole transport layer is deposited only 20 nm thick on an emission area corresponding to the green emission part G, and only 50 nm thick on the blue emission part B. Next, the same material of the hole transport layer is wholly deposited such that its thickness is 50 nm commonly for the RGB emission areas. In this way, the hole transport layer having different thickness for each of the emission areas of RGB is formed. After depositing the hole transport layer, emission layers 33R, 33G, 33B are deposited respectively, and then a common electron transport layer 23 is deposited and thus an organic function layer is completed, and then a second electrode (cathode) 14 comprising, for example, metal is formed on the organic function layer, thereby an organic EL display panel can be produced. In this case, sheet resistance of the electron transport layer (hole transport layer) in the organic EL element is different from that of the common gap filling part, which is lower than that of the gap filling part of the element by a degree corresponding to the increased thickness.

**Claims**

1. An organic electroluminescence display panel comprising a plurality of organic electroluminescence elements, each of the elements comprising first and second display electrodes and at least one of organic function layers including an emission layer comprising an organic compound, the function layers being sandwiched and stacked between the first and second display electrodes, and a substrate supporting the plurality of organic electroluminescence elements; wherein the organic function layers include at least one common layer that is formed commonly for the plurality of organic electroluminescence elements and has charge transport properties, and the common layer has a gap filling part extending among the plurality of organic electroluminescence elements, wherein the sheet resistance $\rho s\_ctl\_min$ of the gap filling part is a value satisfying a formula

$$\rho s\_ctl \geq (V\_on(K-1) - V\_off) \cdot (K-1)/(I\_const \cdot a),$$

where K indicates a maximum gray-scale number for display, V_on(K-1) indicates voltage between the first and second display electrodes of the organic electroluminescence element without the electric leakage at the maxium gray-scale in the on-state, V_off indicates the voltage between the first and second display electrodes of the organic electroluminescence element that is adjoining in the off-state, I_const indicates driving current having a constant value, and a indicates the coefficient obtained from the shape of the gap filling part, respectively.

2. An organic electroluminescence display panel comprising a plurality of organic electroluminescence elements, each of the elements comprising first and second display electrodes and at least one of organic function layers including an emission layer comprising an organic compound, the function layers being sandwiched and stacked between the first and second display electrodes, and a substrate supporting the plurality of organic electroluminescence elements; wherein the organic function layers include at least one common layer that is formed commonly for the plurality of organic electroluminescence elements and has charge transport properties, and the common layer has a gap filling part extending among the plurality of organic electroluminescence elements, wherein the sheet resistance $\rho s\_ctl\_min$ of the gap filling part is a value satisfying a formula

$$\rho s\_ctl \geq (V\_on(K-1)-V\_off) \cdot (K-1)/(a \cdot I(K-1)),$$

where K indicates a maximum gray-scale number for display, $V\_on(K-1)$ indicates voltage between the first and second display electrodes of the organic electroluminescence element without the electric leakage at the maximum gray-scale in the on-state, $V\_off$ indicates the voltage between the first and second display electrodes of the organic electroluminescence element that is adjoining in the off-state, $I(K-1)$ indicates electric current flowing into the organic electroluminescence element at the maximum gray-scale, and a indicates the coefficient obtained from the shape of the gap filling part, respectively.

**Patentansprüche**

1. Anzeigefeld organischer Elektrolumineszenz mit mehreren Elementen organischer Elektrolumineszenz, wobei jedes der Elemente eine erste und eine zweite Anzeigeelektrode und mindestens eine von organischen Funktionsschichten mit einer Emissionsschicht mit einer organischen Verbindung umfasst, wobei die Funktionsschichten zwischen der ersten und der zweiten Anzeigeelektrode sandwichartig angeordnet und gestapelt sind, und ein Substrat die mehreren Elemente organischer Elektrolumineszenz trägt; wobei die organischen Funktionsschichten mindestens eine gemeinsame Schicht umfassen, die gemeinsam für die mehreren Elemente organischer Elektrolumineszenz ausgebildet ist und Ladungstransporteigenschaften aufweist, und die gemeinsame Schicht einen Lückenfüllteil aufweist, der sich unter den mehreren Elementen organischer Elektrolumineszenz erstreckt, wobei der Flächenwiderstand $\rho s\_ctl$ des Lückenfüllteils ein Wert ist, der die Formel

$$\rho s\_ctl \geq (V\_on(K-1)-V\_off) \cdot (K-1)/(I\_const \cdot a)$$

erfüllt, wobei jeweils K eine maximale Graustufenzahl für eine Anzeige angibt, $V\_on(K-1)$ eine Spannung zwischen der ersten und der zweiten Anzeigeelektrode des Elements organischer Elektrolumineszenz ohne den elektrischen Leckverlust bei der maximalen Graufstufe im Ein-Zustand angibt, $V\_off$ die Spannung zwischen der ersten und der zweiten Anzeigeelektrode des angrenzenden Elements organischer Elektrolumineszenz im Aus-Zustand angibt, $I\_const$ einen Treiberstrom mit einem konstanten Wert angibt und a den Koeffizienten angibt, der aus der Form des Lückenfüllteils erhalten wird.

2. Anzeigefeld organischer Elektrolumineszenz mit mehreren Elementen organischer Elektrolumineszenz, wobei jedes der Elemente eine erste und eine zweite Anzeigeelektrode und mindestens eine von organischen Funktionsschichten mit einer Emissionsschicht mit einer organischen Verbindung umfasst, wobei die Funktionsschichten zwischen der ersten und der zweiten Anzeigeelektrode sandwichartig angeordnet und gestapelt sind, und ein Substrat die mehreren Elemente organischer Elektrolumineszenz trägt; wobei die organischen Funktionsschichten mindestens eine gemeinsame Schicht umfassen, die gemeinsam für die mehreren Elemente organischer Elektrolumineszenz ausgebildet ist und Ladungstransporteigenschaften aufweist, und die gemeinsame Schicht einen Lückenfüllteil aufweist, der sich unter den mehreren Elementen organischer Elektrolumineszenz erstreckt, wobei der Flächenwiderstand $\rho s\_ctl$ des Lückenfüllteils ein Wert ist, der die Formel

$$\rho s\_ctl \geq (V\_on(K-1)-V\_off) \cdot (K-1)/(a \cdot I(K-1))$$

erfüllt, wobei jeweils K eine maximale Graustufenzahl für eine Anzeige angibt, $V\_on(K-1)$ eine Spannung zwischen der ersten und der zweiten Anzeigeelektrode des Elements organischer Elektrolumineszenz ohne den elektrischen Leckverlust bei der maximalen Graufstufe im Ein-Zustand angibt, $V\_off$ die Spannung zwischen der ersten und der zweiten Anzeigeelektrode des angrenzenden Elements organischer Elektrolumineszenz im Aus-Zustand angibt, I (K-1) einen elektrischen Strom, der bei der maximalen Graustufe in das Element organischer Elektrolumineszenz fließt, angibt und a den Koeffizienten angibt, der aus der Form des Lückenfüllteils erhalten wird.

## Revendications

**1.** Panneau d'affichage électroluminescent organique comprenant une pluralité d'éléments électroluminescents organiques, chacun des éléments comprenant une première et une seconde électrode d'affichage et au moins une couche fonctionnelle organique incluant une couche d'émission comprenant un composé organique, les couches fonctionnelles étant prises en sandwich et empilées entre la première et la seconde électrode d'affichage, et un substrat supportant la pluralité d'éléments électroluminescents organiques ; dans lequel les couches fonctionnelles organiques incluent au moins une couche commune qui est formée en commun pour la pluralité d'éléments électroluminescents organiques et qui présente des propriétés de transport de charges, et la couche commune comporte une partie de remplissage de lacune s'étendant parmi la pluralité d'éléments électroluminescents organiques, dans lequel la résistance en feuilles $\rho s\_ctl$ de la partie remplissage de lacune est une valeur satisfaisant une formule :

$$\rho s\_ctl \geq (V\_on\,(K - 1) - V\_off) \cdot (K - 1)/(I\_const \cdot a),$$

dans laquelle K indique un nombre d'échelles de gris maximum pour l'affichage, V_on (K - 1) indique le voltage entre la première et la seconde électrode d'affichage de l'élément électroluminescent organique sans fuite électrique à l'échelle de gris maximum dans l'état en fonctionnement, V_off indique le voltage entre la première et la seconde électrode d'affichage de l'élément électroluminescent organique qui rejoint un l'état à l'arrêt, I_const indique un courant de pilotage ayant une valeur constante, et a indique le coefficient obtenu à partir de la forme de la partie de remplissage de lacune, respectivement.

**2.** Panneau d'affichage électroluminescent organique comprenant une pluralité d'éléments électroluminescents organiques, chacun des éléments comprenant une première et une seconde électrode d'affichage et au moins une couche fonctionnelle organique incluant une couche d'émission comprenant un composé organique, les couches fonctionnelles étant prises en sandwich et empilées entre la première et la seconde électrode d'affichage, et un substrat supportant la pluralité d'éléments électroluminescents organiques, dans lequel les couches fonctionnelles organiques incluent au moins une couche commune qui est formée en commun pour la pluralité d'éléments électroluminescents organiques et qui présente des propriétés de transport de charges, et la couche commune comprend une partie de remplissage de lacune qui s'étend au milieu de la pluralité d'éléments électroluminescents organiques, dans lequel la résistance en feuilles $\rho s\_ctl$ de la partie de remplissage de lacune est une valeur satisfaisant la formule

$$\rho s\_ctl \geq (V\_on\,(K - 1) - V\_off) \cdot (K - 1)/(a \cdot I\,(K - 1)),$$

dans laquelle K indique un nombre d'échelles de gris maximum pour l'affichage, V_on (K - 1) indique une tension entre la première et la seconde électrode d'affichage de l'élément électroluminescent organique sans apparition d'une fuite électrique alors que le l'échelle de gris maximum est dans l'état de marche, V_off indique la tension entre la première et la seconde électrode d'affichage de l'élément électroluminescent organique qui est adjacent dans l'état d'arrêt, I (K - 1) indique le courant électrique qui s'écoule dans l'élément électroluminescent organique à l'échelle de gris maximum, et a indique le coefficient obtenu à partir de la forme de la partie de remplissage de lacune, respectivement.

# FIG. 1

# FIG. 2

# FIG. 3

# FIG. 4

GF

14
37
37a
32
36
1

12

# FIG. 5

GF

14
37
32
39
38
1

12    36

# FIG. 6A

# FIG. 6B

# FIG. 7A

# FIG. 7B

# FIG. 8

D   L

M

# FIG. 9

Mx   Dx

My   12D

Dy

# FIG. 10

12S

Di

# FIG. 11

33R    33G    33B
32R    32G    32B

14

34

(R)    (G)    (B)    1

12    GF    12    GF    12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000150152 A
- JP 11087062 A
- JP 2003045665 A
- JP KOKAIH1092584 A